Europäisches Patentamt

European Patent Office

Office européen des brevets

(19)

(11) Publication number : **0 411 657 B1**

(12) **EUROPEAN PATENT SPECIFICATION**

(45) Date of publication of patent specification :
04.01.95 Bulletin 95/01

(51) Int. Cl.⁶ : **G05F 3/30**

(21) Application number : **90114964.1**

(22) Date of filing : **03.08.90**

(54) **Constant voltage circuit.**

(30) Priority : **03.08.89 JP 201851/89**

(43) Date of publication of application :
**06.02.91 Bulletin 91/06**

(45) Publication of the grant of the patent :
**04.01.95 Bulletin 95/01**

(84) Designated Contracting States :
**DE FR GB**

(56) References cited :
**EP-A- 0 288 939
WO-A-85/02472
US-A- 4 100 477
US-A- 4 176 308
US-A- 4 725 770
PATENT ABSTRACTS OF JAPAN vol. 9, no. 99
(E-311)(1822) 27 April 1985, & JP-A-59 224923**

(73) Proprietor : **KABUSHIKI KAISHA TOSHIBA
72, Horikawa-cho
Saiwai-ku
Kawasaki-shi Kanagawa-ken 210 (JP)**

(72) Inventor : **Nitta, Shouzou, c/o Intellectual
Property Div.
K.K. Toshiba,
1-1 Shibaura
1-chome, Minato-ku, Tokyo 105 (JP)**
Inventor : **Sumimoto, Yasuhiro, c/o Intellectual
Property Div.
K.K. Toshiba,
1-1 Shibaura
1-chome, Minato-ku, Tokyo 105 (JP)**

(74) Representative : **Ritter und Edler von Fischern,
Bernhard,Dipl.-Ing. et al
Hoffmann, Eitle & Partner,
Patentanwälte,
Postfach 81 04 20
D-81904 München (DE)**

## Description

The present invention relates to a constant voltage circuit comprising:

a bandgap reference circuit for connection between first and second source voltage supply terminals and including a current mirror circuit, a first resistor having one terminal connected to an output terminal to pass an output current of the current mirror circuit, and a bipolar feedback transistor whose base-emitter path is connected between the other terminal of the resistor and the second voltage supply terminal.

Such a circuit may be used in a bias circuit such as an ECL (emitter-coupled logic) gate array, and is described in WO-A-8502472.

Another bandgap voltage reference circuit is described in EP-A-0288939.

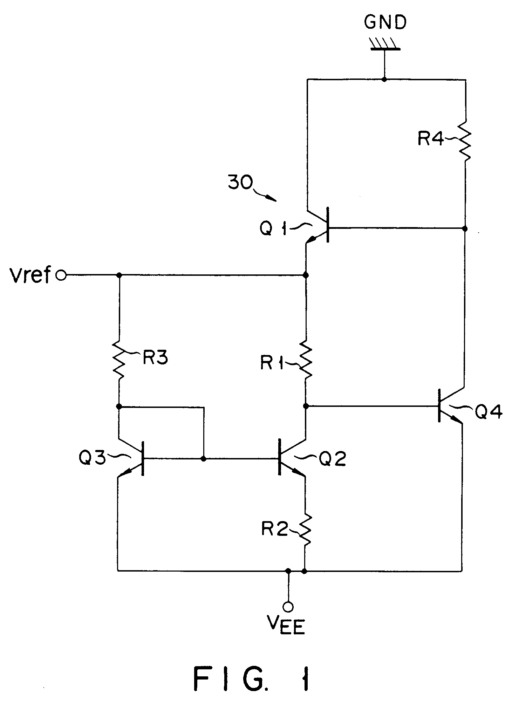

Fig. 1 of the accompanying drawings shows a conventional Widler type bandgap circuit 30 used in a constant voltage circuit. In the bandgap circuit 30, a collector-emitter path of a first npn transistor Q1, a first resistor R1, a collector-emitter path of a second npn transistor Q2, and a second resistor R2 are connected in series with each other between a ground voltage GND and a negative source voltage $V_{EE}$ in the order named.

A third resistor R3 and a collector-emitter path of a third npn transistor Q3, the collector and base of which are connected to each other, are connected in series with each other between the emitter (output terminal) of the first transistor Q1 and the negative source voltage $V_{EE}$ in the order named.

In addition, a fourth resistor R4 and a collector-emitter path of a fourth npn transistor Q4 are connected in series with each other between the ground voltage GND and the negative source voltage $V_{EE}$ in the order named. The collector of the fourth npn transistor Q4 is connected to the base of the first npn transistor Q1, and the base of the fourth npn transistor Q4 is connected to the collector of the second npn transistor Q2. The collector and base of the third npn transistor Q3 are connected to the base of the second npn translst Q2.

In the above-described bandgap circuit 30, the difference $\Delta V_{BE}$ between a voltage of a base-emitter path of the transistor Q3 and a voltage of a base-emitter path of the transistor Q2 appears across the resistor R2. The voltage difference $\Delta V_{BE}$ is multiplied with R1/R2, and the product appears across the resistor R1. The sum of the voltage $\Delta V_{BE} \cdot R1/R2$ across the resistor R1 and a voltage of a base-emitter path of the transistor Q4 $\Delta V_{BE4}$, that is,

$$(\Delta V_{BE} \cdot R1/R2) + V_{BE4} \quad (1)$$

is an output voltage $V_{ref}$. Since the first term of equation (1) has a positive temperature coefficient, and the second term has a negative temperature coefficient, by adjusting the value of the resistor R1, a constant voltage output having a temperature coefficient of zero can be obtained. The value of the output voltage $V_{ref}$ with respect to the negative source voltage $V_{EE}$ is stabilized. That is, it is assumed that the output current increases. When the output current increases, a current flowing in the resistor R1 decreases. The base current of the transistor Q4 is decreased by the decrease in current flowing in the resistor R1. Then, the collector current of the transistor Q4 decreases. When the collector current of the transistor Q4 decreases, the base current of the transistor Q1 increases.

In the bandgap circuit 30 described above, however, the negative feedback function by the transistor Q4 against variations in negative source voltage $V_{EE}$ is not always sufficient, so that variations in output voltage $V_{ref}$ do not sufficiently follow those in negative source voltage $V_{EE}$. Therefore, the difference between the output voltage $V_{ref}$ and the negative source voltage $V_{EE}$ is not kept constant, so that the output current flowing into the load side unexpectedly varies.

As described above, in the conventional bandgap circuit, a constant voltage output can be obtained against variations in temperature. The negative feedback function by the transistor Q4 is, however, not always sufficient against the variations in negative source voltage $V_{EE}$. Therefore, the variations in output voltage $V_{ref}$ do not sufficiently follow those in negative source voltage $V_{EE}$, the difference between the output voltage $V_{ref}$ and the negative source voltage $V_{EE}$ is not kept constant, and the output current flowing into the load side unexpectedly varies, resulting in inconvenience.

It is an object of the present invention to provide a constant voltage circuit wherein an output voltage accurately follows variations in source voltage and any difference between an output voltage and a source voltage is stabilized.

According to the invention, the constant voltage circuit initially defined is characterized by:

a further bipolar transistor, the collector of which is connected to the collector of said feedback transistor, and the base of which is connected to a voltage source free from variations in source voltage applied to said supply terminals; and

a second resistor connected between the emitter of said further bipolar transistor and said second source voltage supply terminal.

This invention can be more fully understood from the following detailed description when taken in conjunction with the accompanying drawings, in which:

Fig. 1 is a circuit diagram showing a conventional Widler type bandgap circuit used in a constant voltage circuit;

Fig. 2 is a circuit diagram showing a constant voltage circuit according to the present invention used in a bias circuit of an ECL gate array; and

Fig. 3 is a circuit diagram showing a practical arrangement of a voltage source in Fig. 2.

An embodiment of the present invention will be described in detail with reference to the accompanying drawings hereinafter.

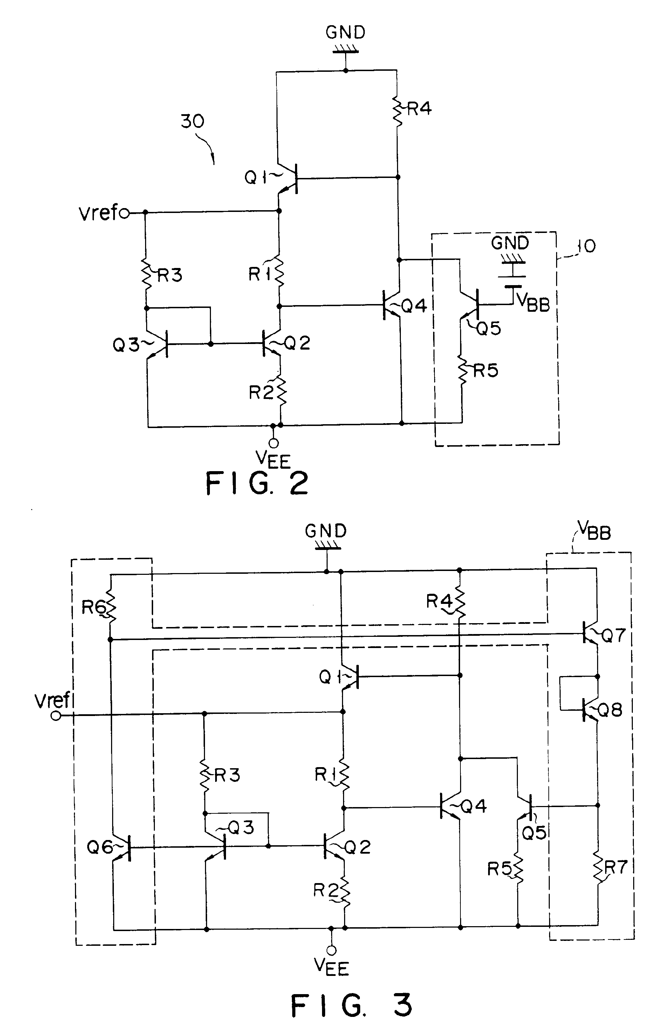

Fig. 2 shows a constant voltage circuit used in a bias circuit of an ECL gate array. The constant voltage circuit is different from the conventional bandgap circuit 30 described above with reference to Fig. 1 in additionally comprising a feedback loop 10. Therefore, the same reference numerals as in Fig. 1 denote the same or corresponding parts in Fig. 2, and its explanation will be omitted.

The feedback loop 10 is, for example, as shown in Fig. 2, constituted by a fifth npn transistor Q5, the collector of which is connected to the collector of a transistor Q4, and a fifth resistor R5 connected between the emitter of the fifth npn transistor Q5 and a negative source voltage $V_{EE}$. The base of the fifth npn transistor Q5 is connected to a stabilized voltage source $V_{BB}$ free from variations in negative source voltage $V_{EE}$.

An operation of the above-described constant voltage circuit is essentially the same as the operation of the conventional bandgap circuit 30 described above with reference to Fig. 1. By adding the feedback loop 10, however, the operation which will be described later can be performed. That is, when, for example, the negative source voltage $V_{EE}$ decreases, an ON current of the transistor Q5 increases and a larger amount of current is pulled up through a resistor R4. As a result, the base voltage of Q1 and, hence, the emitter voltage decrease, so that an output voltage $V_{ref}$ decreases. In contrast, when the negative source voltage $V_{EE}$ increases, the ON current of the transistor Q5 decreases, a smaller amount of current is pulled up through the resistor R4. As a result, the base voltage of the transistor Q1 and, hence, its emitter voltage increase, so that the output voltage $V_{ref}$ increases. As described above, variations in output voltage $V_{ref}$ perfectly follow those in negative source voltage $V_{EE}$. Therefore, a difference between the output voltage $V_{ref}$ and the negative source voltage is kept constant.

Fig. 3 is a practical circuit arrangement of the voltage source $V_{BB}$ in Fig. 2. The same reference numerals as in Fig. 2 denote the same parts in Fig. 3.

The voltage source $V_{BB}$ is arranged as shown in Fig. 3. A sixth resistor R6 and a collector-emitter path of a sixth npn transistor Q6 are connected in series with each other between the ground voltage GND and the negative source voltage $V_{EE}$ in the order named. The sixth resistor R6 and the sixth npn transistor Q6 constitute a constant voltage generating circuit. Note that, the sixth npn transistor Q6 serves as a constant current source, and the sixth resistor R6 is arranged so as to cause the negative constant voltage in reference to ground voltage GND. A collector-emitter path of a seventh npn transistor Q7, a collector-emitter path of a eighth npn transistor Q8, the collector and the base of which are connected to each other, and a seventh resistor R7 are connected in series with each other between the ground voltage GND and the negative source voltage $V_{EE}$ in the order named. The seventh npn transistor Q7 and the eighth npn transistor Q8 are arranged so as to cause a constant voltage generated by the sixth resistor R6 and the sixth transistor Q6 to drop by a predetermined voltage.

The base of the sixth npn transistor Q6 is connected to the bases of a second npn transistor Q2 and a third npn transistor Q3. The base of the seventh npn transistor Q7 is connected to the collector of the sixth npn transistor Q6. The emitter of the eighth npn transistor Q8 is connected to the base of a fifth npn transistor Q5.

In the constant voltage circuit shown in Fig. 3, a constant current flows through the transistor Q6 for constant current source so that a constant voltage is generated at the connecting point of the resistor R6 and the collector of the transistor Q6. A level of the constant voltage is shifted so as to be supplied to the base of the transistor Q5 in a feedback loop. In this case, a constant voltage generated at the connecting point of the resistor R6 and the collector of the transistor Q6 has a predetermined difference in voltage from the ground voltage GND, so as not to be easily affected by the variations in negative source voltage $V_{EE}$. Therefore, feedback by the feedback loop is effectively performed.

Note that, in the above embodiment, the constant voltage circuit connected between the ground voltage GND and the negative source voltage $V_{EE}$ is shown. The present invention is applicable to a constant voltage circuit connected between a positive source voltage and a ground voltage GND. Note that, a plurality of transistors connected in series with each other, base-collector paths of which are connected to each other, can be used instead of the transistor Q8. In addition, one or a plurality of diodes connected in series can be used instead of the transistor Q8.

Since the basic arrangement is a bandgap circuit, a constant voltage output can be obtained against variations in temperature. In addition, by adding a feedback loop, variations in output voltage perfectly follow those in source voltage, so as to keep the difference between the output voltage and the source voltage constant.

## Claims

1. A constant voltage circuit comprising:
    a bandgap reference circuit (30) for connection between first and second source voltage supply terminals (GND, $V_{EE}$) and including a current mirror circuit, a first resistor (R1) having one terminal connected to an output terminal ($V_{REF}$) to pass an output current of the current mirror circuit, and a bipolar feedback transistor (Q4) whose base-emitter path is connected between the other terminal of the resistor (R1) and the second voltage supply terminal ($V_{EE}$) characterized by;

a further bipolar transistor (Q5), the collector of which is connected to the collector of said feedback transistor (Q4), and the base of which is connected to a voltage source ($V_{BB}$) free from variations in source voltage applied to said supply terminals; and

a second resistor (R5) connected between the emitter of said further bipolar transistor (Q5) and said second source voltage supply terminal ($V_{EE}$).

2. A circuit according to Claim 1 wherein said voltage source ($V_{BB}$) comprises voltage generating means (R6, Q6), connected between said voltage supply terminals ($V_{EE}$, GND) for generating a predetermined voltage higher than the voltage supplied across said source supply terminals, and voltage dropping means (Q7, Q8) for causing the voltage generated by said voltage generating means (R6, Q6) to drop and for supplying the reduced voltage to the base of said further transistor (Q5).

3. A circuit according to Claim 2, wherein said voltage generating means is constituted by a constant current source (Q6) and a third resistor (R6), and said voltage dropping means is constituted by a third transistor (Q7), the base of which receives the voltage generated by said voltage generating means (R6, Q6), at least one diode (Q8) connected to said third transistor (Q7), and a fourth resistor (R7).

4. A circuit according to Claim 3, wherein said constant current source of said voltage generating means (R6, Q6) is a fourth transistor (Q6).

**Patentansprüche**

1. Konstantspannungsschaltung, umfassend: eine Bandabstands-Referenzschaltung (30) zur Verbindung zwischen ersten und zweiten Quellenspannungs-Versorgungsanschlüssen (GND, $V_{EE}$) und mit einer Stromspiegelschaltung, einem ersten Widerstand (R1), der einen Anschluß aufweist, der mit einem Ausgangsanschluß ($V_{REF}$) verbunden ist, um einen Ausgangsstrom der Stromspiegelschaltung durchzulassen, und mit einem bipolaren Rückkopplungstransistor (Q4), dessen Basis-Emitter-Pfad zwischen den anderen Anschluß des Widerstands (R1) und den zweiten Spannungs-Versorgungsanschluß ($V_{EE}$)

geschaltet ist, gekennzeichnet durch: einen weiteren bipolaren Transistor (Q5), dessen Kollektor mit dem Kollektor des Rückkopplungstransistors (Q4) verbunden ist und dessen Basis mit einer von Veränderungen in der Quellenspannung freien Spannungsquelle ($V_{BB}$) verbunden ist, die an die Versorgungsanschlüsse angeschlossen ist; und einen zweiten Widerstand (R5), der zwischen den Emitter des weiteren bipolaren Transistors (Q5) und den zweiten Quellenspannungs-Versorgungsanschluß ($V_{EE}$) geschaltet ist.

2. Schaltung nach Anspruch 1, dadurch gekennzeichnet, daß die Spannungsquelle ($V_{BB}$) umfaßt: eine Spannungserzeugungseinrichtung (R6, Q6), die zwischen die Spannungs-Versorgungsanschlüsse ($V_{EE}$, GND) geschaltet ist, um eine vorgegebene höhere Spannung als die über die Quellen-Versorgungsanschlüsse gelieferte Spannung zu erzeugen, und eine Spannungs-Abfalleinrichtung (Q7, Q8), um die durch die Spannungs-Erzeugungseinrichtung (R6, Q6) erzeugte Spannung zu veranlassen, abzufallen und um die reduzierte Spannung an die Basis des weiteren Transistors (Q5) zu führen.

3. Schaltung nach Anspruch 2, dadurch gekennzeichnet, daß die Spannungs-Erzeugungseinrichtung aus einer Konstantstromquelle (Q6) und einem dritten Widerstand (R6) bersteht, und die Spannungs-Abfalleinrichtung aus einem dritten Transistor (Q7), dessen Basis die durch die Spannung-Erzeugungseinrichtung (R6, Q6) erzeugte Spannung empfängt, wenigstens einer mit dem dritten Transistor (Q7) verbundenen Diode (Q8) und einem vierten Widerstand (R7) gebildet ist.

4. Schaltung nach Anspruch 3, dadurch gekennzeichnet, daß die Konstantstromquelle der Spannungs-Erzeugungseinrichtung (R6, Q6) ein vierter Transistor (Q6) ist.

**Revendications**

1. Circuit à tension constante comportant : un circuit de référence d'intervalle de bande (30) monté entre des première et seconde bornes d'alimentation de tension (GND, $V_{EE}$) et comprenant un circuit miroir de courant, une première résistance (R1) ayant une borne reliée à une borne de sortie ($V_{ref}$) pour transmettre un courant de sortie du circuit miroir de courant et un transistor de rétroaction bipolaire (Q4) dont le trajet base-émetteur est connecté entre l'autre borne de la résistance (R1) et la seconde borne d'alimentation en tension ($V_{EE}$), caractérisé par :

un autre transistor bipolaire (Q5) dont le collecteur est relié au collecteur dudit transistor de rétroaction (Q4), et dont la base est reliée à une source de tension ($V_{BB}$) exempte de variations de la tension d'alimentation appliquée auxdites bornes d'alimentation ; et

une seconde résistance (R5) montée entre l'émetteur dudit autre transistor bipolaire (Q5) et ladite seconde borne d'alimentation en tension ($V_{EE}$).

2. Circuit selon la revendication 1, dans lequel ladite source de tension ($V_{BB}$) comporte des moyens de génération de tension (R6, Q6), montés entre lesdites bornes d'alimentation en tension ($V_{EE}$, GND) pour générer une tension prédéterminée supérieure à la tension appliquée auxdites bornes d'alimentation, et des moyens de réduction de tension (Q7, Q8) pour provoquer une baisse de la tension générée par lesdits moyens de génération de tension (R6, Q6) et pour appliquer la tension réduite à la base dudit autre transistor (Q5).

3. Circuit selon la revendication 2, dans lequel lesdits moyens de génération de tension sont constitués par une source à courant constant (Q6) et une troisième résistance (R6), et lesdits moyens de réduction de tension sont constitués par un troisième transistor (Q7), dont la base reçoit la tension générée par lesdits moyens de génération de tension (R6, Q6), au moins un diode (Q8) relié audit troisième transistor (Q7), et une quatrième résistance (R7).

4. Circuit selon la revendication 3, dans lequel ladite source à courant constant desdits moyens de génération de tension (R6, Q6) est un quatrième transistor (Q6).

FIG. 1

FIG. 2

FIG. 3